(19) Europäisches Patentamt

European Patent Office

Office européen des brevets

(11) **EP 1 016 203 B1**

(12) **EUROPÄISCHE PATENTSCHRIFT**

(45) Veröffentlichungstag und Bekanntmachung des Hinweises auf die Patenterteilung:
**19.12.2001   Patentblatt 2001/51**

(51) Int Cl.⁷: **H02M 3/335**, H04N 5/63

(21) Anmeldenummer: **98949902.5**

(22) Anmeldetag: **14.08.1998**

(86) Internationale Anmeldenummer:
**PCT/DE98/02380**

(87) Internationale Veröffentlichungsnummer:
**WO 99/14845 (25.03.1999 Gazette 1999/12)**

(54) **SCHALTUNGSANORDNUNG ZUR BESTIMMUNG DER AUSGANGSLEISTUNG EINES SCHALTNETZTEILS**

CIRCUIT FOR DETERMINING THE OUTPUT POWER OF SWITCHED-MODE POWER SUPPLY

CIRCUIT SERVANT A DETERMINER LA PUISSANCE DE SORTIE D'UNE ALIMENTATION A DECOUPAGE

(84) Benannte Vertragsstaaten:
**DE ES FI FR GB IT**

(30) Priorität: **17.09.1997  DE 19740932**

(43) Veröffentlichungstag der Anmeldung:
**05.07.2000   Patentblatt 2000/27**

(73) Patentinhaber: **Infineon Technologies AG
81669 München (DE)**

(72) Erfinder:
• **NIEDERREITER, Hans
D-84453 Mühldorf (DE)**
• **PRELLER, Peter
D-81243 München (DE)**

(74) Vertreter: **Zedlitz, Peter, Dipl.-Inf. et al
Patentanwalt, Postfach 22 13 17
80503 München (DE)**

(56) Entgegenhaltungen:
**EP-A- 0 744 818          DE-A- 3 129 021
US-A- 4 996 638**

• **PATENT ABSTRACTS OF JAPAN vol. 13, no. 136
(E-737), 5. April 1989 & JP 63 299778 A
(MATSUSHITA ELECTRIC), 7. Dezember 1988**

**Beschreibung**

Die Erfindung betrifft Schaltungsanordnungen zur Bestimmung der Ausgangsleistung von Schaltnetzteilen.

Schaltnetzteile zeichnen sich dadurch aus, daß sie eine möglichst von der Last unabhängige, konstant ausgeregelte Gleichspannung liefern. Die Abgabeleistung kann dabei einen größeren Bereich umfassen. Der Abgabeleistungsbereich eines Schaltnetzteils beispielsweise für Fernsehgeräte kann von 5 W bis 150 W reichen. Bei niedriger abgegebener Leistung wird oft eine niedrige Schaltfrequenz eingestellt um Schaltverluste zu minimieren oder Schaltungsteile des Fernsehgerätes werden ein- oder ausgeschaltet.

Dazu muß die Momentanleistung des Schaltnetzteils primärseitig gemessen und in geeigneter Weise zur Steuerung der Frequenz oder von Schaltungsteilen aufbereitet werden. Eine einfache Art, die Leistung zu bestimmen, besteht darin, den Primärstrom im Schalttransistor durch einen Meßwiderstand zu messen. Die Leistung ist zum Quadrat des Stroms proportional. Da die Höhe dieses Stroms auch stark von der Frequenz und der Eingangsspannung abhängt, ist diese Art der Leistungsbestimmung sehr ungenau.

Aus der DE 3 129 021 A1 ist eine Schaltungsanordnung zur Messung der Durchgangsleistung in Gleichstrom-Transformatoren bekannt. Die Anordnung eignet sich nur für Transformatoren, die mit konstanter Frequenz getaktet sind.

Aufgabe der vorliegenden Erfindung ist es, eine Schaltungsanordnung anzugeben, mit der auf einfache Weise eine einfache Bestimmung eines Maßes für die Ausgangsleistung eines Schaltnetzteils möglich ist.

Diese Aufgabe wird gemäß der Erfindung mit einer Schaltungsanordnung mit den Merkmalen des Anspruches 1 gelöst.

Die erfindungsgemäße Schaltungsanordnung hat den Vorteil, daß mit ihr ein Maß für die Abgabeleistung eines Schaltnetzteils unabhängig von der Frequenz und der Eingangsspannung bestimmt werden kann.

Weiterhin ist der geringe schaltungstechnische Aufwand der Schaltungsanordnung von Vorteil.

Die Schaltungsanordnung liefert eine der Abgabeleistung eines Schaltnetzteils proportionale Spannung. Diese kann beispiels-weise auf einen oder mehrere Komparatoren gegeben werden, die zur Umschaltung der gewünschten Funktion, zum Beispiel der Frequenz, in einfacher Weise dienen.

Der Energiespeicher der erfindungsgemäßen Schaltungsanordnung ist vorzugsweise als Kapazität ausgeführt.

Das Integrationsglied integriert die über ihn anliegende Spannung. Es besteht vorzugsweise aus einem RC-Glied. Sein Zeitverhalten kann über den Betrag des Widerstandes und der Kapazität des RC-Gliedes eingestellt werden.

Die erfindungsgemäße Schaltungsanordnung zur Leistungsmessung läßt sich in vielfacher Art anwenden. Sie wird vorzugsweise dann eingesetzt, wenn die Frequenz leistungsabhängig und mit nur kleiner Hysterese umgeschaltet werden soll, wie bei-spielsweise bei der Leistungsmessung im Standby-Burstbetrieb. Ein weiterer Anwendungsfall für die erfindungsgemäße Schaltungsanordnung ist der sog. temporäre Hochlastbetrieb. Hier wird innerhalb des Leistungsbereichs eines Schaltnetzteils eine Schwelle für die gemessene Abgabeleistung festgelegt, die nur kurzzeitig überschritten werden darf. Bei längerem Überschreiten dieser Schwelle tritt dann eine Schutzschaltung in Funktion, die beispielsweise das Schaltnetzteil ausschaltet. Dadurch wird eine erhöhte Sicherheit erreicht, da durch das Abschalten bei dauernder Überlast eine Brandgefahr vermieden wird.

Ein weiterer Vorteil ergibt sich aus der Kosteneinsparung, da das Schaltnetzteil bezüglich der entstehenden Verlustwärme nur für die wesentlich kleinere Dauerleistung und nicht für die kurzzeitige Spitzenleistung ausgelegt werden muß. Dies wiederum erlaubt die Verwendung kleinerer Transformatoren und kleinerer Kühlbleche.

Weitere vorteilhafte Aus- und Weiterbildungen sind in Unteransprüchen gekennzeichnet.

Die Erfindung wird nachfolgend anhand von Figuren und einem Ausführungsbeispiel näher erläutert. Es zeigen:

Figur 1    Spannungs- und Stromverläufe bei einer Leistungsmessung,

Figur 2    eine erfindungsgemäße Schaltungsanordnung und

Figur 3    Transformator-Entladeströme bei verschiedenen Frequenzen.

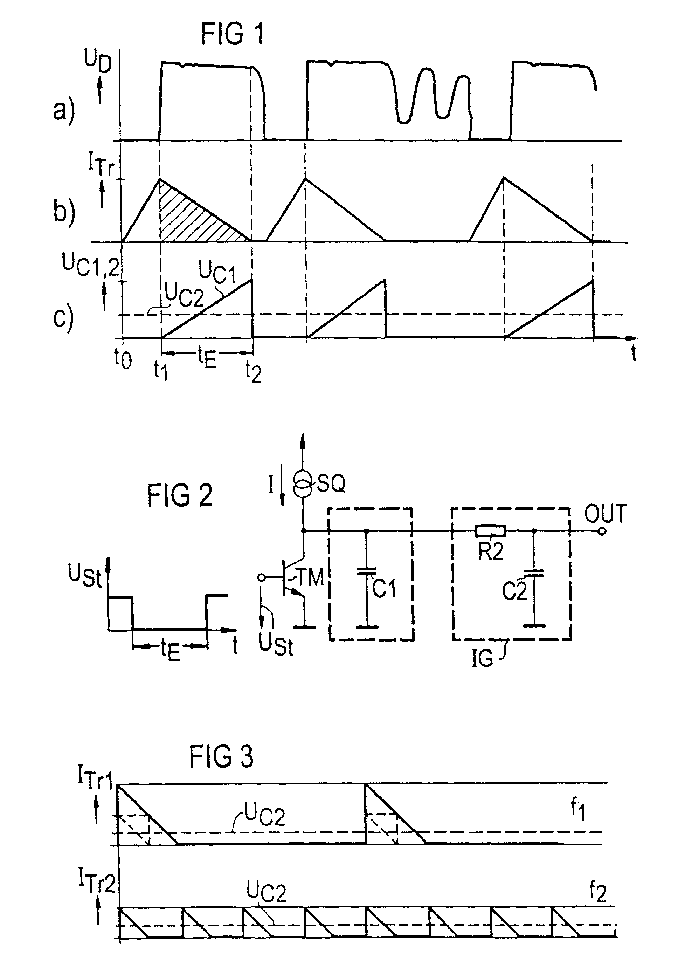

Bekanntlich wird bei einem Schaltnetzteil der durch die Primärwicklung eines Schaltnetzteiltransformators fließende Strom mittels eines Schalttransistors zerhackt. Als Schalttransistor wird üblicherweise ein Leistungs-MOSFET verwendet. In Figur 1a ist die Drainspannung eines solchen Schalttransistors eines Schaltnetzteils dargestellt. Während einer Einschaltzeit, die von dem Zeitpunkt $t_0$ bis zum Zeitpunkt $t_1$ reicht und in der der Schaltnetzteiltransformator aufgeladen wird, ist die Drainspannung $U_D$ praktisch Null Volt. Innerhalb einer Entladezeit $t_E$ zwischen den Zeitpunkten $t_1$ und $t_2$ kann die Drainspannung einige Hundert Volt erreichen. Während der Entladezeit $t_E$ wird der Schaltnetzteiltransformator entladen. Während einer Schaltnetzteilperiode wird also der Transformator über die Primärseite mit einem bestimmten Energieinhalt geladen, den er anschließend an die Sekundärseite wieder abgibt.

In Figur 1b ist der Auf- und Entladestrom eines Transformators in einem Schaltnetzteil aufgetragen. Der Aufladestrom steigt von Null Ampere während der Einschaltzeit des Schalttransistors bis zum Zeitpunkt $t_1$

an, zu dem der Schalttransistor ausgeschaltet wird. In der anschließenden Entladezeit $t_E$ sinkt der Entladestrom des Transformators bis zum Zeitpunkt $t_2$ wieder auf Null Ampere. Ein erneutes Aufladen des Transformators erfolgt erst, wenn die Drainspannung des Schalttransistors wieder auf Null V gesunken ist. Die Pausen zwischen Endladung und anschließender Aufladung des Transformators können unterschiedlich sein und hängen von der Abgabeleistung des Schaltnetzteils ab.

Die elektrische Arbeit W berechnet sich allgemein zu:

$$(1) \qquad W = \int U(t) \cdot I(t) \; dt$$

Die Ausgangsspannungen von Schaltnetzteilen sind geregelt. Die Beträge der Ausgangsspannungen sind weitgehend unabhängig von der entnommenen Leistung immer konstant. Es gilt also die folgende Beziehung:

$$(2) \qquad U(t) = U_{konst}$$

Gleichung (1) vereinfacht sich daher folgendermaßen:

$$(3) \qquad W = U_{konst} \int I(t) \; dt$$

Die elektrische Leistung P berechnet sich aus der Arbeit wie folgt:

$$(4) \qquad P = \frac{dW}{dt}$$

Da der Entladestrom des Schaltnetzteils, wie oben beschrieben, sägezahnförmig verläuft und Pausen aufweist, erfolgt die Leistungsmessung über die jeweils gespeicherte Energie im Transformator.
Da die Aufladezeit des Transformators von der Netzspannung abhängt und diese zur Leistungsmessung deshalb mitberücksichtigt werden müßte, ist es einfacher, die Leistung während der Entladezeit $t_E$ des Transformators zu messen. Die Spannung des Transformators ist dann konstant. Der Energieinhalt W des Transformators ist dann die Fläche unter der Kurve für den Entladestrom $I_{Tr}(t)$ während der Entladezeit $t_E$.
In Figur 1b ist diese Fläche schraffiert dargestellt. Die Energie des Transformators, bezogen auf eine ganze Schaltnetzteilperiode, ist also ein Maß für die Leistung des Schaltnetzteiles während dieser Periode. Durch Mittelung der Flächen über mehrere Perioden erhält man die mittlere Leistung des Schaltnetzteils während dieser Perioden.

Die Schaltungsanordnung zur Leistungsmessung nach Figur 2 weist einen Energiespeicher C1 und ein Integrationsglied IG auf. Als Energiespeicher dient im Ausführungsbeispiel eine Ladekapazität C1, die zwischen eine Stromquelle SQ und ein Bezugspotential, beispielsweise Masse, geschaltet ist. Für das Integrationsglied ist ein RC-Glied vorgesehen, bei dem ein Widerstand R2 zwischen die Stromquelle SQ und einen Ausgang OUT der Schaltungsanordnung geschaltet ist. Eine Integrationsapazität C2 des RC-Gliedes ist zwischen den Ausgang OUT und das Bezugspotential geschaltet. Die Konstantstromquelle SQ ist zudem über einen Transistor TM mit dem Bezugspotential derart verbunden, daß bei geeigneter Ansteuerung des Steuereingangs des Transistors TM mit der Spannung $U_{St}$ der Strom der Stromquelle SQ zu dem Bezugspotential abgeleitet wird.

Die Stromquelle SQ ist vorzugsweise als Konstaktstromquelle ausgeführt, die unabhängig von der an ihr angeschlossenen Last einen konstanten Strom I liefert.

Den bevorzugten zeitlichen Verlauf der Steuerspannung $U_{S_-}$ des Transistors TM ist ebenfalls in Figur 2 dargestellt. Während der Entladezeit $t_E$ ist die Steuerspannung $U_{St}$ gleich Null, so daß der Transistor TM sperrt. Zu Zeitpunkten außerhalb der Entladezeit $t_E$ ist die Steuerspannung $U_{St}$ ungleich Null und so bemessen, daß der Transistor TM durchschaltet.
Die Entladezeit $t_E$ kann ohne größeren Aufwand beispielsweise mit einer Komparatorschaltung ermittelt werden. Sie ist die Zeitdauer während eines Schaltzyklus, in dem die Drainspannung des Schalttransistors des Schaltnetzteils eine bestimmte Schwelle überschreitet.
Während der Entladezeit $t_E$ wird die Ladekapazität C1 durch den konstanten Strom I aufgeladen, so daß die Spannung an C1 $U_{C1}$ rampenförmig ansteigt. Am Ende der Entladezeit $t_E$ zum Zeitpunkt $t_2$ wird die Ladekapazität C1 durch den Transistor T schnell entladen. In Figur 1c ist der Spannungsverlauf an der Ladekapazität C1 als durchgezogene Linie eingetragen. Der beschriebene Auf- und Entladevorgang wiederholt sich bei jeder Schaltnetzteilperiode. Die Spannung an der Ladekapazität C1 $U_{C1}$ wird durch das nachgeschaltete Integrationsglied IG integriert. Die Spannung über der Integrationskapazität C2 $U_{C2}$ entspricht der Ausgangsspannung am Ausgang OUT der Schaltungsanordnung und ist proportional zur mittleren Leistung des Schaltnetzteils. Diese Spannung $U_{C2}$ kann unmittelbar, wie eingangs beschrieben, einem Komparator zugeführt werden, um beispielsweise eine bestimmte Betriebsart einzuschalten.

Das RC-Glied aus dem Widerstand R2 und der Integrationskapazität C2 ist vorzugsweise hochohmig ausgelegt, damit durch einen Strom durch den Widerstand R2 die Spannung $U_{C1}$ über der Ladekapazität C1 nicht verfälscht wird. Das Zeitverhalten des RC-Gliedes ist von der Dimensionierung des Widerstandes R2 und der Integrationskapazität C2 bestimmt.

Während der Entladezeit $t_E$ ist der Transistor TM gesperrt. Der Strom I der Stromquelle SQ lädt die Ladekapazität C1 auf. Die Spannung über der Ladekapazität C1 wird von dem Integrationsglied IG integriert, so daß die Spannung der Integrationskapazität C2 proportional zur mittleren Leistung des Schaltnetzteiles ist. Nach der Entladezeit $t_E$, also zum Zeitpunkt $t_2$, wird die Ladekapazität C1 über den dann durchgeschalteten Transistor TM entladen. Der folgende Ladevorgang ist also unabhängig vom zuvor erreichten Ladezustand der Ladekapazität C1.

In Figur 3 sind Transformator-Entladeströme $I_{Tr1}$ und $I_{Tr2}$ bei gleicher Abgabeleistung und zwei verschiedenen Frequenzen $f_1$ und $f_2$ dargestellt. Die Frequenz $f_2$ ist viermal höher als die Frequenz $f_1$. Die Flächeninhalte der Dreiecke repräsentieren jeweils die im Transformator gespeicherte Energie während der Entladezeit $t_E$. Bei der Frequenz $f_1$ ist die gespeicherte Energie während einer Entladeperiode viermal so groß wie bei der Frequenz $f_2$. Die bei der Frequenz $f_1$ gestrichelt eingetragenen Dreiecke sind jeweils flächengleich mit einem der Dreiecke bei der Frequenz $f_2$. Im zeitlichen Mittel über vier Perioden oder ein Vielfaches davon ergibt sich unabhängig von der Frequenz jeweils die gleiche Fläche. Die mittlere Leistung ist also in beiden Fallen gleich, obwohl der Transformatorstrom $I_{Tr1}$ bei der Frequenz $f_1$ doppelt so groß ist wie der Transformatorstrom $I_{Tr2}$ bei der Frequenz $f_2$. Die Gleichspannung an der Integrationskapazität C2 des Integrationsgliedes IG ist jeweils als gestrichelte Linie eingezeichnet. Sie gibt die mittlere Leistung an und ist für beide Frequenzen gleich groß. Man erkennt, daß die Transformator-Entladeströme kein Maß für die mittlere Leistung sind. Die erfindungsgemäße Schaltungsanordnung berücksichtigt diesen Umsrand.

Schaltnetzteile für Monitore werden oft mit deren Zeilenfrequenz synchronisiert, um Störeinkopplungen des Schaltnetzteils auf einen Bildschirm gering zu halten. Der Frequenzbereich der Zeilenfrequenz liegt in der Regel je nach eingestellter Auflösung und Bildwiederholfrequenz des Monitors zwischen 30 kHz und 110 kHz. Solche Schaltnetzteile für Monitore müssen also für diesen Frequenzbereich ausgelegt werden. Eine Leistungsbegrenzung erfolgt bei diesen Schaltnetzteilen meist durch Begrenzung des primären Pulsstroms durch den Schalttransistor auf einen von der Schaltfrequenz abhängigen Höchstwert.

Dieser Höchstwert muß bei höheren Schaltfrequenzen kleiner sein als bei niedrigeren, wenn die dem Schaltnetzteil entnehmbare Leistung ungefähr konstant bleiben soll. Wird der Höchstwert für die niedrigste Schaltfrequenz fest eingestellt, nimmt die entnehmbare Leistung bei höheren Schaltfrequenzen gegenüber der bei kleineren Frequenzen zu. Das kann zu Überhitzung von Bauteilen und damit zu Brandgefahr im Fehlerfall führen.

Eine thermische Auslegung des Schaltnetzteils auf die größtmögliche entnehmbare Leistung erfordert entsprechend groß dimensionierte Bauteile und ist daher teuer. Mit der erfindungsgemäßen Schaltungsanordnung kann eine frequenzunabhängige Leistungsmessung auf der Primärseite des Schaltnetzteils erfolgen, um eine Leistungsbegrenzung zu erreichen.

**Patentansprüche**

1. Schaltungsanordnung zur Bestimmung eines Maßes für die Ausgangsleistung eines Schaltnetzteils, das einen Transformator aufweist, dessen Primärseite über einen Feldeffekttransistor mit Energie, die er während einer Entladezeit ($t_E$) an die Sekundärseite abgibt, versorgt wird, mit einem Integrationsglied (IG), **dadurch gekennzeichnet, daß**

   - ein Energiespeicher (C1), der durch eine Konstantstromquelle (SQ) mit einem Strom (I) während einer Dauer, in der die Drainspannung des Feldeffekt-Trnsistors eine bestimmte Schwelle überschreitet, geladen und in der übrigen Zeit über einen Schalter (TM) entladen wird und daß das

   - Integrationsglied (IG mit dem Energiespeicher (C1) verbunden ist und die Spannung über dem Energiespeicher (C1) integriert und diese als Maß für die Ausgangsleistung des Schaltnetzteiles einem Ausgang (OUT) zuführt.

2. Schaltungsanordnung zur Bestimmung der Ausgangsleistung eines Schaltnetzteils nach Anspruch 1, dadurch h **gekennzeichnet**, daß der Energiespeicher als Ladekapazität (C1) ausgeführt ist.

3. Schaltungsanordnung zur Bestimmung der Ausgangsleistung eines Schaltnetzteils nach einem der Ansprüche 1 oder 2, **dadurch gekennzeichnet, daß** das Integrationsglied (IG) ein RC-Glied aus einem Widerstand (R2) und einer Integrationskapazität (C2) aufweist.

4. Schaltungsanordnung zur Bestimmung der Ausgangsleistung eines Schaltnetzteils nach Anspruch 2 oder 3, **dadurch gekennzeichnet, daß** die Konstantstromquelle (SQ) mit der Ladekapazität (C1) und dem Widerstand R2) verbunden ist und so an den Schalter (TM) angeschlossen ist, daß bei geschlossenem Schalter (TM) der Strom der Konstantstromquelle (SQ nach Masse abgeleitet wird.

**Claims**

1. Circuit arrangement for determining a measure of the output power of a switched-mode power supply which has a transformer whose primary side is supplied with energy via a field-effect transistor and which outputs the said energy to the secondary side during a discharge time ($t_E$), having an integration element (IG), **characterized in that**

- an energy store (C1) is charged by a constant-current source (SQ) with a current (I) during a period in which the drain voltage of the field-effect transistor exceeds a specific threshold, and is discharged via a switch (TM) the rest of the time, and **in that**
- the integration element (IG) is connected to the energy store (C1) and integrates the voltage across the energy store (C1) and feeds this to an output (OUT) as a measure of the output power of the switched-mode power supply.

**2.** Circuit arrangement for determining the output power of a switched-mode power supply according to Claim 1, **characterized in that** the energy store is embodied as a charging capacitance (C1).

**3.** Circuit arrangement for determining the output power of a switched-mode power supply according to either of Claims 1 and 2, **characterized in that** the integration element (IG) has an RC element comprising a resistor (R2) and an integration capacitance (C2).

**4.** Circuit arrangement for determining the output power of a switched-mode power supply according to Claim 2 or 3, **characterized in that** the constant-current source (SQ) is connected to the charging capacitance (C1) and the resistor (R2) and is connected to the switch (TM) in such a way that when the switch (TM) is closed, the current of the constant-current source (SQ) is discharged to earth.

**Revendications**

**1.** Montage pour déterminer une mesure de la puissance de sortie d'une alimentation à découpage qui comporte un transformateur dont le côté primaire est alimenté par l'intermédiaire d'un transistor à effet de champ en énergie qu'il fournit pendant une durée ($t_E$) de décharge au côté secondaire, comportant un élément (IG) d'intégration, **caractérisé en ce que**

- un accumulateur (C1) d'énergie est chargé par une source (SQ) de courant constant en un courant (I) pendant une durée pendant laquelle la tension de drain du transistor à effet de champ est supérieure à un seuil déterminé et est déchargé pendant le temps restant par l'intermédiaire d'un interrupteur (TM) et en ce que
- l'élément (IG) d'intégration est relié à l'accumulateur (C1) d'énergie et la tension aux bornes de l'accumulateur (C1) d'énergie est intégrée et celle-ci est envoyée à une sortie (OUT) comme mesure de la puissance de sortie de l'alimentation à découpage.

**2.** Montage pour déterminer la puissance de sortie d'une alimentation à découpage suivant la revendication 1, **caractérisé en ce que** l'accumulateur d'énergie est réalisé en capacité (C1) de charge.

**3.** Montage pour déterminer la puissance de sortie d'une alimentation à découpage suivant l'une des revendications 1 ou 2, **caractérisé en ce que** l'élément (IG) d'intégration comporte un élément (RC) constitué d'une résistance (R2) et d'une capacité (C2) d'intégration.

**4.** Montage pour déterminer la puissance de sortie d'une alimentation à découpage suivant la revendication 2 ou 3, **caractérisé en ce que** la source (SQ) de courant constant est reliée à la capacité (C1) de charge et à la résistance (R2) et est raccordée à l'interrupteur (TM) de telle manière que, lorsque l'interrupteur est fermé, le courant de la source (SQ) de courant constant est dérivé vers la masse.

## FIG 1

a) $U_D$

b) $I_{Tr}$

c) $U_{C1,2}$ $U_{C1}$ $U_{C2}$

$t_0$ $t_1$ $t_E$ $t_2$ $t$

## FIG 2

$U_{St}$ $t_E$ $t$

$I$ SQ

TM $U_{St}$

C1 OUT

R2 C2

IG

## FIG 3

$I_{Tr1}$ $U_{C2}$ $f_1$

$I_{Tr2}$ $U_{C2}$ $f_2$